# EUROPÄISCHE PATENTSCHRIFT

(11) **EP 2 797 176 B1**
(45) Veröffentlichungstag und Bekanntmachung des Hinweises auf die Patenterteilung: **29.06.2016**
(21) Anmeldenummer: 13165541.7
(22) Anmeldetag: 26.04.2013
(51) Int. Cl.: H01R 13/516, H01R 13/66, H01R 13/64

(54) **Sensoreinheit**
Sensor unit
Capteur

(43) Veröffentlichungstag der Anmeldung: 29.10.2014
(73) Patentinhaber: VEGA Grieshaber KG, 77709 Wolfach (DE)
(72) Erfinder: Ilg, Thomas, 77756 Hausach (DE)
(74) Vertreter: Westphal, Mussgnug & Partner Patentanwälte mbB

(56) Entgegenhaltungen:
- DE-A1- 10 019 294
- DE-A1- 10 139 202
- FR-A1- 2 734 085
- US-A- 5 318 459

## Beschreibung

Die vorliegende Erfindung betrifft eine Sensoreinheit gemäß dem Oberbegriff des Patentanspruchs 1.

Aus dem Stand der Technik sind verschiedentlich Sensoreinheiten mit einem Sensor, einer mit dem Sensor verbundenen Sensorelektronik und einer ersten Verbindungseinheit, die mit der Sensorelektronik verbunden ist, bekannt, wobei der Sensor, die Sensorelektronik und die erste Verbindungseinheit in einem rohrförmigen Gehäuse angeordnet sind und wobei die erste Verbindungseinheit mit einer korrespondierend ausgebildeten zweiten Verbindungseinheit kontaktierbar ist. Die zweite Verbindungseinheit stellt dabei üblicherweise eine Verbindung zur Warte und/oder einer Auswerteelektronik über eine Kabelverbindung her. In Fällen, bei denen mit den Verbindungseinheiten nicht nur eine Steckverbindung sondern darüber hinaus eine mechanisch stabile und gegebenenfalls gegen eine Prozessumgehung abgedichtete Verbindung geschaffen werden muss ist es üblich, dass die zweite Verbindungseinheit in das rohrförmige Gehäuse beispielsweise mit einer Überwurfmutter eingeschraubt wird.

Bei dem Festschrauben der zweiten Verbindungseinheit in dem rohrförmigen Gehäuse, beispielsweise über die erwähnte Überwurfmutter können beim Einschraubvorgang in Umfangsrichtung wirkende Drehmomente von der Überwurfmutter auf die zweite Verbindungseinheit und über diese auf die erste Verbindungseinheit und damit auf die mit dieser Verbindungseinheit verbundenen Komponenten, d. h. die Sensorelektronik sowie den damit verbundenen Sensor übertragen werden. Solche Drehmomente können, insbesondere wenn sie sich bis in den Bereich des Sensors fortpflanzen zu Messfehlern führen.

Darüber hinaus können sich solche Drehmomente negativ auf eine Verbindung zwischen der ersten Verbindungseinheit und der Sensorelektronik und/oder der Verbindung zwischen der Sensorelektronik und dem Sensor auswirken, was beides beispielsweise bei einem Verbindungsbruch zu einem Ausfall der Sensoreinheit führt.

Zur Vermeidung der zuvor beschriebenen Messfehler und Sensorausfälle wird im Stand der Technik eine Bearbeitung des Gehäuses derart vorgeschlagen, dass dieses beispielsweise durch Fräsen mit einer oder mehreren Halteflächen versehen wird. Die zweite Verbindungseinheit ist dazu korrespondierend mit Halteflächen versehen, so dass ein Drehmoment, das bei einem Befestigen der zweiten Verbindungseinheit in dem Gehäuse entsteht unmittelbar über die Halteflächen auf das Gehäuse übertragen wird. Auf diese Weise kann eine Fortpflanzung des eingebrachten Drehmoments auf die erste Verbindungseinheit, die Sensorelektronik sowie den Sensor vermieden werden.

An dem vorbeschriebenen Vorgehen wird es als nachteilig empfunden, dass für die Einbringung entsprechender Halteflächen eine aufwändige Bearbeitung jedes einzelnen Gehäuses notwendig ist.

Die FR 2734085 A1 offenbart Verbinder, die ein Verbinden eines Elektrokabels mit einem Ultraschallsensor zur Ultraschallwasserortung ermöglichen. Die US 5318459 offenbart einen schnell zu trennenden, flüssigkeitsdichten elektrischen Verbinder, mit dem elektrische Kabel rasch an Schaltkreise, die in Gehäusen untergebracht sind, angeschlossen werden können. Ein elektrischer Verteiler mit einem Gehäuse, wenigstens zwei Anschlußeinrichtungen und einer Mehrzahl von Verbindungselementen ist in der DE 10139202 A1 beschrieben.

Bei der aus dem Stand der Technik bekannten Ausgestaltungsform, bei der eine Drehmomentübertragung von dem Stecker unmittelbar auf das Gehäuse erfolgt, ist, bedingt durch die in dem im Gehäuse vorgesehenen Halteabschnitte, eine definierte Ausrichtung der Buchse relativ zu diesen Halteabschnitten notwendig. Eine derartige Ausrichtung ist vergleichsweise aufwändig und kann, wenn sie nicht präzise durchgeführt ist, beim Einbringen des Steckers in das Gehäuse zu einer Klemmwirkung zwischen dem Stecker und der Buchse führen.

Es ist die Aufgabe der vorliegenden Erfindung eine Sensoreinheit zur Verfügung zu stellen, die die aus dem Stand der Technik bekannten Nachteile nicht aufweist.

Diese Aufgabe wird durch eine Sensoreinheit mit den Merkmalen des Patentanspruchs 1 gelöst.

Vorteilhafte Weiterbildungen sind Gegenstand abhängiger Patentansprüche.

Eine erfindungsgemäße Sensoreinheit mit einem Sensor, einer mit dem Sensor verbundenen Sensorelektronik und einer ersten Verbindungseinheit, die mit der Sensorelektronik verbunden ist, wobei der Sensor, die Sensorelektronik und die erste Verbindungseinheit in einem rohrförmigen Gehäuse angeordnet sind und wobei die erste Verbindungseinheit mit einer korrespondierend ausgebildeten zweiten Verbindungseinheit kontaktierbar ist, zeichnet sich dadurch aus, dass in dem Gehäuse ein Formteil mit einer Innenkontur des Formteils drehfest angeordnet ist, wobei die Innenkontur und eine Außenkontur der ersten Verbindungseinheit, und optional der zweiten Verbindungseinheit, wenigstens abschnittsweise korrespondierend zueinander ausgebildet sind und die Innenkontur wenigstens einen Halteabschnitt aufweist, der derart ausgebildet ist, dass ein Verdrehen der ersten, und optional der zweiten Verbindungseinheit, relativ zu dem Formteil verhindert wird.

Erfindungsgemäß wird damit die aus dem Stand der Technik bekannte Sensoreinheit derart weitergebildet, dass eine Drehmomentübertragung nicht unmittelbar von der zweiten Verbindungseinheit, beispielsweise einem Stecker, auf das Gehäuse erfolgt, sondern dass ein separates Formteil vorgesehen ist, das zur Übertragung des Drehmoments auf das Gehäuse dient. Durch eine drehfeste Anordnung des separaten Formteils innerhalb des Gehäuses vorzugsweise durch einen Reibschluss, der beispielsweise durch ein Einpressen des Formteils in das Gehäuse erzeugt wird, kann auf eine aufwändige Bearbeitung des Gehäuses verzichtet werden, wobei gleichzeitig eine zuverlässige Aufnahme eines eingebrachten Drehmoments durch das Gehäuse gewährleistet ist. Ein entsprechendes Drehmoment, das beispielsweise durch das Festziehen eine Überwurfmutter in die Anordnung eingebracht wird kann entweder unmittelbar von der zweiten Verbindungseinheit auf das Formteil und damit auf das Gehäuse übertragen werden oder durch eine korrespondierende Ausbildung der Innenkontur des Formteils zu einer Außenkontur der ersten Verbindungseinheit über diese abgeleitet werden.

In jedem der vorgenannten Fälle wird eine Ausbreitung eines eingebrachten Drehmomentes auf die Sensorelektronik sowie den mit der Sensorelektronik verbundenen Sensor vermieden, so dass sowohl drehmomentinduzierte Messfehler als auch drehmomentinduzierte mechanische Probleme zuverlässig vermieden werden.

Um eine zuverlässige Ableitung eines eingebrachten Drehmoments zu erreichen, können bevorzugt mehrere Halteabschnitte an der Innenkontur des Formteils vorgesehen sein. Bevorzugt kann das Formteil mit wenigstens zwei, bevorzugt vier oder sechs Halteabschnitten ausgebildet sein.

Wenn das Formteil mit paarweise gegenüberliegend und parallel verlaufenden Halteabschnitten ausgebildet ist können beispielsweise durch Ausbildung der Innenkontur als Rechteck regelmäßiges Sechseck oder regelmäßiges Achteck Innenkonturen geschaffen werden, die einfach herzustellen sind und gleichzeitig eine Variation der Einbauposition der mit dem Formteil verbundenen Verbindungseinheit relativ zu dem Formteil erlauben.

In einer weiteren Ausgestaltungsform ist die Innenkontur mit wenigstens einer nach außen weisenden Ausnehmung und die Außenkontur mit wenigstens einem nach innen weisenden und in die Ausnehmung eingreifenden Vorsprung ausgebildet, wodurch in diesem Ausführungsbeispiel der wenigstens eine Halteabschnitt gebildet ist. Durch das Vorsehen einer einzigen solchen Ausnehmung und eines einzigen dazu korrespondierenden Vorsprungs kann eine eindeutige Einbauposition der Verbindungseinheit relativ zu dem Formteil festgelegt werden.

Durch das Vorsehen einer Vielzahl nach außen weisender Ausnehmungen bei dem Formteil kann eine Innenkontur geschaffen werden, die beispielsweise sternförmig ausgebildet ist. Eine sternförmig ausgebildete Innenkontur ermöglicht dann wieder die Variation einer Einbauposition der mit dem Formteil in Verbindung stehenden Verbindungseinheit relativ zu dieser, so dass eine erhöhte Flexibilität beim Einbau geschaffen wird.

In einer bevorzugten Ausgestaltungsform der Sensoreinheit ist das Formteil in das Gehäuse eingepresst eingeklebt, eingeschweißt (z.B. Laserschweißen) oder eingelötet (z.B. Hartlöten).

Durch ein Einpressen Einkleben, Schweißen oder Einlöten eines Formteils in das Gehäuse wird eine schnelle und kostengünstige Montage erreicht, die eine zuverlässige Übertragung eines Drehmoments von dem Formteil auf das Gehäuse gewährleistet.

Da das Formteil innerhalb des Gehäuses der Sensoreinheit angeordnet ist besteht die Möglichkeit, das Formteil.beispielsweise auf Kunststoff zu fertigen. Eine besonders einfache Ausgestaltung sieht vor, dass das Formteil aus Kunststoff gefertigt und in eine Spritzgussverfahren hergestellt ist, wodurch eine äußerst kostengünstige Variante geschaffen wird.

In einer alternativen Ausgestaltung ist das Formteil aus Metall gefertigt und bevorzugt in einem Druckgussverfahren hergestellt. Dadurch, dass das Formteil nicht der auf das Gehäuse einwirkenden Prozessumgebung ausgesetzt ist, kann es beispielsweise aus Aluminium gefertigt sein.

In einer bevorzugten Ausgestaltungsform stellen die Verbindungseinheiten eine elektrische Verbindung her, wobei die erste Verbindungseinheit als Buchse und die zweite Verbindungseinheit als Stecker ausgebildet ist.

In einer bevorzugten Ausgestaltungsform steht die als Buchse ausgebildete erste Verbindungseinheit in Verbindung mit dem Formteil, wobei die Buchse bevorzugt Rastelemente aufweist, die das Formteil zur axialen Fixierung der Buchse an dem Formteil rastend hintergreifen.

Eine bevorzugte Ausgestaltungsform, bei der die zuvor beschriebenen Drehmomente auftreten ist der Stecker derart ausgebildet, dass er in die Buchse eingreift und mittels einer Überwurfmutter an dem Gehäuse befestigbar ist.

Durch eine punktasymmetrische Ausgestaltung der Innenkontur des Formteils kann außerdem eine eindeutige Einbauposition der Verbindungseinheit relativ zu dem Formteil erreicht werden.

Die vorliegende Erfindung wird nachfolgend anhand von Ausführungsbeispielen unter Bezugnahme auf die beigefügten Figuren eingehend erläutert. Es zeigen:
- Figur 1: einen Längsschnitt durch ein Ausführungsbeispiel einer erfindungsgemäßen Sensoreinheit,
- Figur 2: eine perspektivische Darstellung des Steckers aus Figur 1,
- Figur 3: das Gehäuse aus Figur 6 in einer perspektivischen Ansicht von schräg hinten und
- Figuren 4a bis d: verschiedene Ausführungsbeispiele eines Formteils.

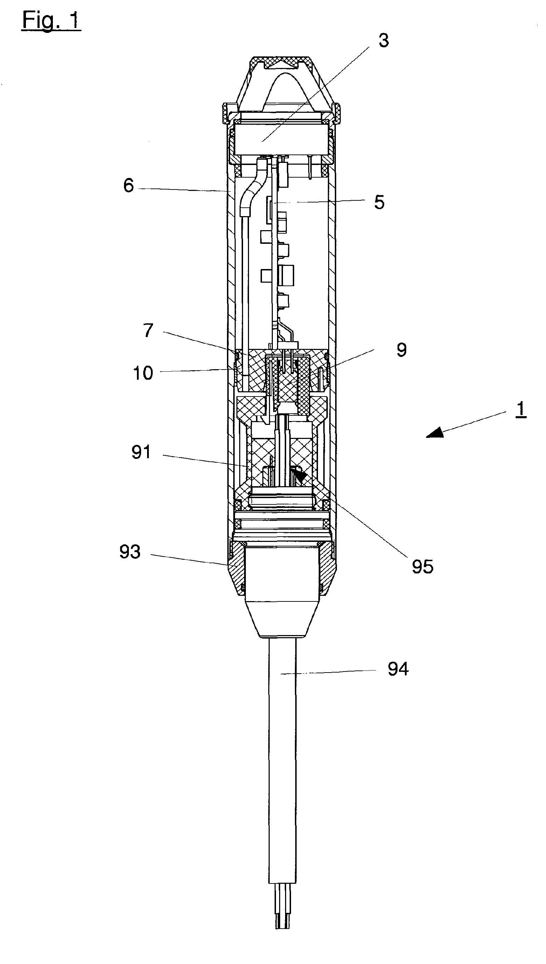

Figur 1 zeigt einen Längsschnitt durch eine Sensoreinheit 1, bei der die vorliegende Erfindung zum Einsatz kommen kann.

Die Sensoreinheit 1 weist ein im Wesentlichen rohrförmig ausgebildetes Gehäuse 6 auf, in dem vorderseitig ein Sensor 3, beispielsweise eine keramische Druckmesszelle, angeordnet ist. Der Sensor 3 ist mit einer innerhalb des Gehäuses 6 angeordneten Sensorelektronik 5 verbunden, die zur Auswertung und Aufbereitung der ermittelten Messsignale dient. An der Sensorelektronik 5 ist rückseitig, d. h. an einem dem Sensor 3 abgewandten Ende der Sensorelektronik 5, eine als Buchse ausgebildete erste Verbindungseinheit 7 angeordnet. Die Buchse 7 dient zur elektrischen und mechanischen Kontaktierung der Sensorelektronik 5, wobei die aufbereiteten Messsignale über eine Mehrzahl von Anschlussstiften zur Verfügung gestellt werden. Über die Buchse 7 ist außerdem eine Inbetriebnahme und Konfiguration der Sensoreinheit 1 möglich.

Die erste Buchse 7 ist rückseitig mit einer zweiten Verbindungseinheit 9, die im vorliegenden Ausführungsbeispiel als Stecker ausgebildet ist, kontaktiert. Der Stecker 9 ist mit einem Steckergehäuse 91 ausgebildet, aus dem rückseitig ein über eine Zugentlastung 95 im Inneren des Steckergehäuses 91 gelagertes Anschlusskabel 94 austritt. Der Stecker 9 ist an dem Gehäuse 6 der Sensoreinheit 1 über eine Überwurfmutter 93, die beispielsweise zur Abdichtung des Gehäuses 6 mit einem Dichtring 96 versehen sein kann, befestigt. Sowohl das Gehäuse 6 als auch wenigstens die mit einer Prozessumgebung in Verbindung stehenden Abschnitte des Steckergehäuses 91 sind vorzugsweise aus einem inerten und wenig korrosionsanfälligen Material, wie beispielsweise Edelstahl oder Titan, gefertigt.

Um eine Übertragung von Drehmomenten, die bei einem Befestigen des Steckers 9 in dem Gehäuse 6 der Sensoreinheit 1 mittels der Überwurfmutter 93 auf die Sensorelektronik 5 und den Sensor 3 zu verhindern, ist die Buchse 7 mittels eines Formteils 10, das drehfest in dem Gehäuse 6 angeordnet ist, gelagert. Das Formteil 10 weist zur Lagerung der Buchse 7 im vorliegenden Ausführungsbeispiel 2 radial gegenüberliegend angeordnete und parallel verlaufende Halteabschnitte auf, die ein Verdrehen der Buchse 7 relativ zu dem Formteil 10 verhindern. Da das Formteil 10 durch ein Einpressen in das Gehäuse 6 in diesem drehfest gelagert ist, wird ein durch das Festziehen der Überwurfmutter 93 erzeugtes Drehmoment über den Stecker 9 auf die Buchse 7 und von dieser über das Formteil 10 auf das Gehäuse 6 abgeleitet und damit eine Ausbreitung des Drehmoments auf die Sensorelektronik 5 sowie den Sensor 3 verhindert.

Die drehfeste Anordnung des Formteils 10 in dem Gehäuse 6 erfolgt beispielsweise durch ein Einpressen oder Einkleben des Formteils 10.

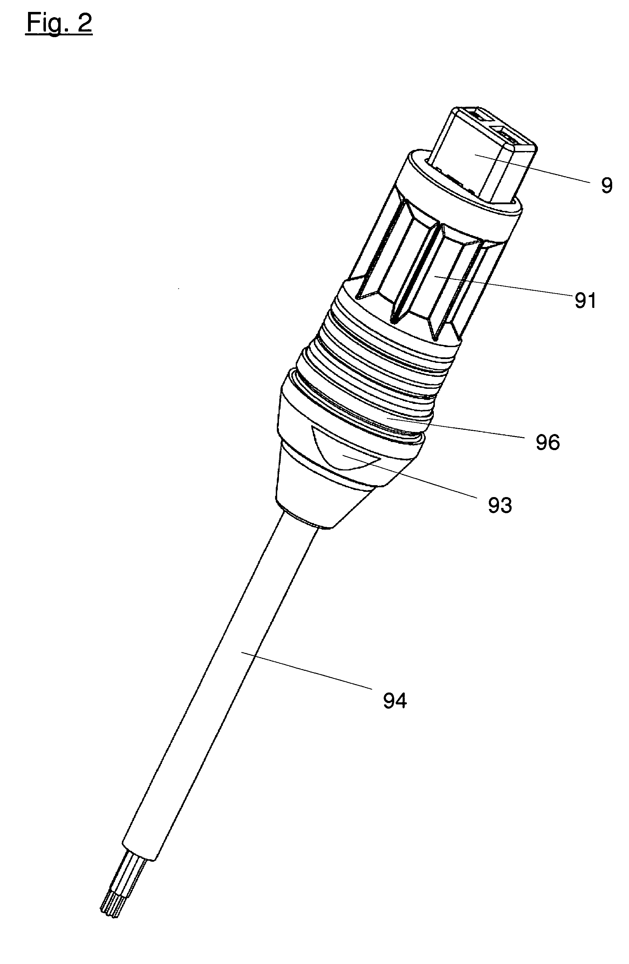

Figur 2 zeigt eine perspektivische Darstellung des Steckers 9, wobei in dieser Darstellung die Anordnung des Dichtrings 96 vorderseitig der Überwurfmutter 93 zur Abdichtung des Gehäuses 6 besonders gut zu erkennen ist.

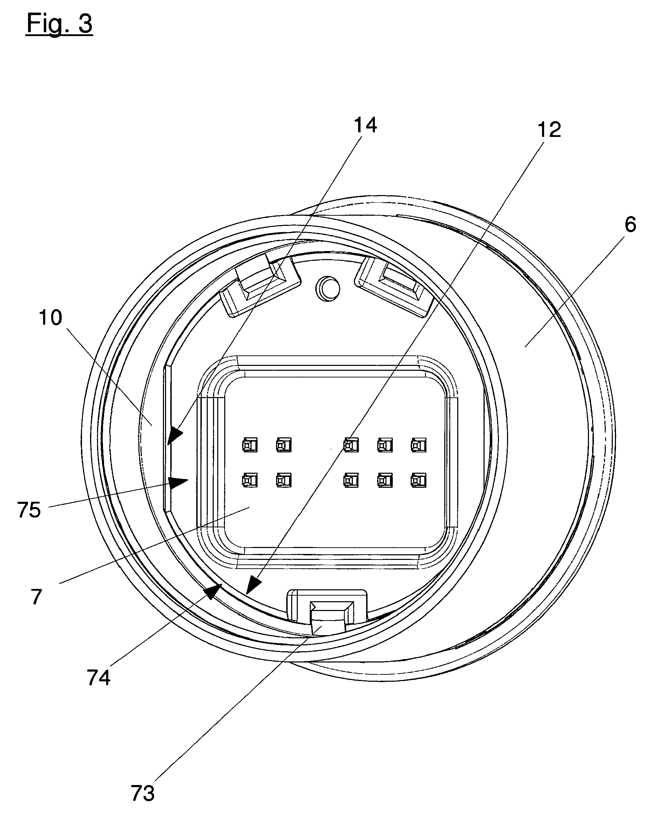

Figur 3 zeigt eine perspektivische Darstellung der Sensoreinheit 1 ohne eingesetzten Stecker 9 in einer Ansicht von schräg hinten.

In der in Figur 3 dargestellten Ansicht ist besonders gut die Lagerung der Buchse 7 in dem Formteil 10 zu erkennen. Das Formteil 10 ist im vorliegenden Ausführungsbeispiel mit einer im Wesentlichen kreisförmig ausgebildeten Innenkontur ausgestaltet, wobei radial gegenüberliegend zwei parallel verlaufende Halteabschnitte 14 vorgesehen sind. Die Buchse 7 weist eine korrespondierend zur Innenkontur 12 des Formteils 10 ausgebildete Außenkontur auf, wobei ebenfalls radial gegenüberliegend parallel verlaufende Halteabschnitte 75 vorgesehen sind, die ein Verdrehen der Buchse 7 relativ zu dem Formteil 10 verhindern. Zur Fixierung der Buchse 7 in Axialrichtung ist diese mit am Außenumfang angeordneten Rastnasen 73 versehen. Die Rastnasen 73 hintergreifen das Formteil 10 in Radialrichtung, so dass eine axiale Bewegung der Buchse 7 relativ zu dem Formteil 10 verhindert wird. Im vorliegenden Ausführungsbeispiel sind an der Buchse 7 drei solche Rastnasen 73 vorgesehen, wobei unterschiedliche Ausgestaltungen beispielsweise mit zwei gegenüberliegend angeordneten Rastnasen 73 ebenfalls denkbar sind.

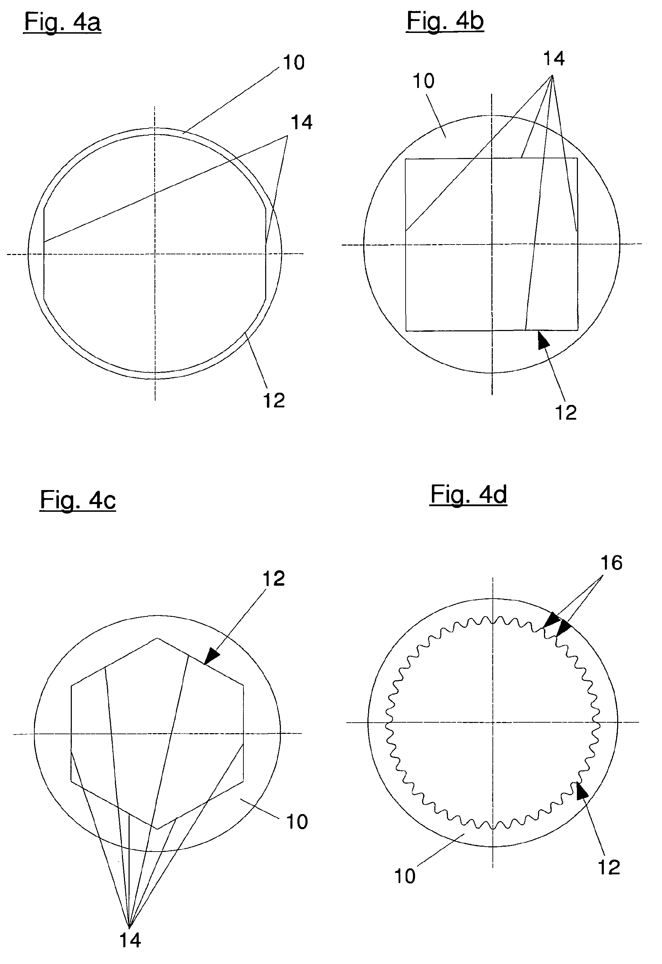

In den Figuren 4a bi 4d sind verschiedene Ausgestaltungen eines Formteils 10, wie es in einer Sensoreinheit 1, wie sie in Figur 1 dargestellt ist, zum Einsatz kommen können, gezeigt.

Figur 4a zeigt das Formteil 10 aus Figur 3. Wie bereits erläutert, weist das Formteil 10 in diesem Ausführungsbeispiel zwei gegenüberliegend angeordnete Halteabschnitte 14 auf, die parallel ausgerichtet in Richtung eines Durchmessers verlaufend am Umfang des Formteils 10 angeordnet sind. Die Innenkontur 12 des Formteils 10 ist damit im Wesentlichen kreisförmig mit zwei gegenüberliegenden Flächenabschnitten als Halteabschnitte 14 ausgestaltet.

Figur 4b zeigt eine zweite Ausgestaltungsform eines Formteils 10, wie es in einer Sensoreinheit 1, wie sie beispielsweise in Figur 1 gezeigt ist, zum Einsatz kommen kann. Das Formteil 10 weist in der dargestellten Ausführungsform eine Innenkontur 12 mit vier Halteabschnitten 14 auf, wobei die Halteabschnitte 14 quadratisch angeordnet sind und so eine quadratische Innenkontur 12 ausbilden.

Figur 4c zeigt eine dritte Ausgestaltungsform eines Formteils 10, wobei die Innenkontur 12 in Form eines regelmäßigen Sechseckes, d. h. mit sechs Halteabschnitten 14 identischer Länge ausgebildet ist, wobei die Halteabschnitte 14 paarweise gegenüberliegend und parallel verlaufend angeordnet sind.

In Figur 4d ist ein viertes Ausführungsbeispiels eines Formteils 10 gezeigt, wobei die Innenkontur 12 sternförmig mit einer Vielzahl von in Radialrichtung nach außen weisende Ausnehmungen 16 ausgebildet ist. Die Innenkontur 12 des Formteils 10 ist damit im Wesentlichen sternförmig ausgestaltet und ermöglicht damit eine Vielzahl von unterschiedlichen Ausrichtungen der Buchse und relativ zum Formteil 10.

Sämtliche der vorgenannten Formteile 10, wie sie in den Figuren 4a bis 4d dargestellt sind, weisen ihrerseits eine kreisrunde Außenkontur auf, und können damit beispielsweise mittels eines Drehverfahrens bearbeitet werden. Die Innenkontur kann beispielsweise durch einen Fräsvorgang erzeugt werden.

Für eine besonders günstige Herstellung der dargestellten Formteile 10 wird jedoch - abhängig vom verwendeten Material - ein Spritzguß-, Druckguss- oder Pulvermetallspritzgussverfahren (MIM = Metal Injection Moulding), oder durch fräsen und drehen gefertigt. Diese Fertigungsprozesse sind in der Fertigungstechnik gut etabliert und können entsprechende Formteile in einem Arbeitsgang ohne aufwändige Nachbearbeitung erzeugen.

### Bezugszeichenliste

- 1: Sensoreinheit
- 3: Sensor
- 5: Sensorelektronik
- 6: Gehäuse
- 7: erste Verbindungseinheit/Buchse
- 9: zweite Verbindungseinheit/Stecker

- 10: Formteil
- 12: Innenkontur
- 14: Halteabschnitt
- 16: Ausnehmung

- 71: Aufnahme nicht in den Bildern markiert
- 73: Rastnasen
- 74: Außenkontur
- 75: Halteabschnitt

- 91: Steckergehäuse
- 93: Überwurfmutter
- 94: Anschlusskabel
- 95: Zugentlastung
- 96: Dichtung

## Patentansprüche

1. Sensoreinheit (1) mit
einem Sensor (3),
einer mit dem Sensor (3) verbundenen Sensorelektronik (5) und
einer ersten Verbindungseinheit (7), die mit der Sensorelektronik (5) verbunden ist,
wobei der Sensor (3), die Sensorelektronik (5) und die erste Verbindungseinheit (7) in einem rohrförmigen Gehäuse (6) angeordnet sind und wobei die erste Verbindungseinheit (7) mit einer korrespondierend ausgebildeten zweiten Verbindungseinheit (9) kontaktierbar ist, **dadu rch gekennzeichnet**, dass
in dem Gehäuse (6) ein Formteil (10) mit einer Innenkontur (12) drehfest angeordnet ist, wobei die Innenkontur (12) des Formteils (10) und eine Außenkontur (74) der ersten Verbindungseinheit (7) wenigstens abschnittsweise korrespondierend zueinander ausgebildet sind, wobei die Innenkontur (12) wenigstens einen Halteabschnitt (14) aufweist, der derart ausgebildet ist, dass ein Verdrehen der ersten Verbindungseinheit (7) relativ zu dem Formteil (10) verhindert wird.

2. Sensoreinheit (1) gemäß Anspruch 1,
**dadurch gekennzeichnet, dass**
das Formteil (10) mit einer Innenkontur (12) mit wenigstens zwei, bevorzugt 4 oder 6 Halteabschnitten (75) ausgebildet ist.

3. Sensoreinheit (1) nach einem der vorhergehenden Ansprüche,
**dadurch gekennzeichnet, dass**
das Formteil (10) mit paarweise gegenüberliegend und parallel verlaufenden Halteabschnitten (75) ausgebildet ist.

4. Sensoreinheit (1) nach einem der vorhergehenden Ansprüche,
**dadurch gekennzeichnet, dass**
das Formteil (10) mit einem Rechteck, regelmäßigen Sechseck oder einem regelmäßigen Vieleck als Innenkontur (12) ausgebildet ist.

5. Sensoreinheit (1) nach einem der Ansprüche 1 oder 2,
**dadurch gekennzeichnet, dass**
die Innenkontur (12) wenigstens eine nach außen weisende Ausnehmung (16) und die Außenkontur (74) wenigstens einen in die Ausnehmung eingreifenden Vorsprung aufweist.

6. Sensoreinheit (1) nach Anspruch 5,
**dadurch gekennzeichnet, dass**
die Innenkontur (12) sternförmig ausgebildet ist.

7. Sensoreinheit (1) gemäß einem der vorhergehenden Ansprüche,
**dadurch gekennzeichnet, dass**
das Formteil. (10) in das Gehäuse (6) eingepresst, eingeklebt, eingeschweißt oder eingelötet ist.

8. Sensoreinheit (1) gemäß einem der vorhergehenden Ansprüche,
**dadurch gekennzeichnet, dass**
das Formteil (10) aus Kunststoff und bevorzugt mit einem Spritzgussverfahren gefertigt ist.

9. Sensoreinheit (1) gemäß einem der Ansprüche 1 bis 7,
**dadurch gekennzeichnet, dass**
das Formteil (10) aus Metall, bevorzugt aus Aluminium und bevorzugt mit einem Druckgussverfahren oder aus Stahl und bevorzugt mit einem Feingussverfahren gefertigt ist.

10. Sensoreinheit gemäß einem der Ansprüche 1 bis 7,
**dadurch gekennzeichnet, dass**
das Formteil (10) mittels eines Metal Injection Moulding Prozesses hergestellt ist.

11. Sensoreinheit gemäß einem der Ansprüche 1 bis 7,
**dadurch gekennzeichnet, dass**
das Formteil (10) mittels eines zerspannenden Verfahren hergestellt wird.

12. Sensoreinheit (1) gemäß einem der vorhergehenden Ansprüche,
**dadurch gekennzeichnet, dass**
die Verbindungseinheiten (7, 9) eine elektrische Verbindung herstellen und die erste Verbindungseinheit (7) als Buchse und die zweite Verbindungseinheit (9) als Stecker ausgebildet ist.

13. Sensoreinheit (1) gemäß Anspruch 1,
**dadurch gekennzeichnet, dass**
die Buchse Rastelemente aufweist, die das Formteil (10) zur axialen Fixierung rastend hintergreifen.

14. Sensoreinheit (1) gemäß einem der Ansprüche 1-13,
**dadurch gekennzeichnet, dass**
der Stecker (9) in die Buchse (7) eingreift und mittels einer Überwurfmutter (93) an dem Gehäuse (6) befestigbar ist.

15. Sensoreinheit (1) gemäß einem der vorhergehenden Ansprüche,
**dadurch gekennzeichnet, dass**
die Innenkontur (12) derart ausgebildet ist, dass eine eindeutige Einbauposition der Verbindungseinheit relativ zu dem Formteil (10) festgelegt ist.

## Claims

1. Sensor unit (1) having
a sensor (3),
sensor electronics (5) connected to the sensor (3)
and
a first connection unit (7) which is connected to the sensor electronics (5),
wherein the sensor (3), the sensor electronics (5) and the first connection unit (7) are arranged in a tubular housing (6) and wherein the first connection unit (7) is able to be contacted with a correspondingly formed second connection unit (9),
**characterised in that**
a moulded part (10) having an inner contour (12) is arranged in the housing (6) in a non-rotatable manner, wherein the inner contour (12) of the moulded part (10) and an outer contour (74) of the first connection unit (7) are formed to at least partially correspond to each other, wherein the inner contour (12) has at least one holding section (14) which is formed in such a way that rotation of the first connection unit (7) relative to the moulded part (10) is prevented.

2. Sensor unit (1) according to claim 1,
**characterised in that**
the moulded part (10) is formed with an inner contour (12) having at least two, preferably 4 or 6, holding sections (75).

3. Sensor unit (1) according to one of the preceding claims,
**characterised in that**
the moulded part (10) is formed with holding sections (75) which run in parallel and are in pairs opposite each other.

4. Sensor unit (1) according to one of the preceding claims,
**characterised in that**
the moulded part (10) is formed with a rectangle, regular hexagon, or a regular polygon as the inner contour (12).

5. Sensor unit (1) according to one of claims 1 or 2,
**characterised in that**
the inner contour (12) has at least one recess (16) pointing outwards and the outer contour (74) has at least one protrusion engaging in the recess.

6. Sensor unit (1) according to claim 5,
**characterised in that**
the inner contour (12) is formed in the shape of a star.

7. Sensor unit (1) according to one of the preceding claims,
**characterised in that**
the moulded part (10) is pressed, glued, welded or soldered into the housing (6).

8. Sensor unit (1) according to one of the preceding claims,
**characterised in that**
the moulded part (10) is made out of plastic and is preferably made using an injection moulding method.

9. Sensor unit (1) according to one of claims 1 to 7,
**characterised in that**
the moulded part (10) is made from metal, preferably from aluminium and preferably using a die casting method or is made from steel and preferably using an investment casting method.

10. Sensor unit according to one of claims 1 to 7,
**characterised in that**
the moulded part (10) is produced by means of a metal injection moulding process.

11. Sensor unit according to one of claims 1 to 7,
**characterised in that**
the moulded part (10) is produced by means of a cutting method.

12. Sensor unit (1) according to one of the preceding claims.
**characterised in that**
the connection units (7, 9) produce an electrical connection and the first connection unit (7) is formed as a socket and the second connection unit (9) is formed as a plug.

13. Sensor unit (1) according to claim 1,
**characterised in that**
the socket has latching elements which engage behind the moulded part (10) in a latching manner for axial fixing.

14. Sensor unit (1) according to one of claims 1 to 13,
**characterised in that**
the plug (9) engages in the socket (7) and is able to be attached to the housing (6) by means of a union nut (93).

15. Sensor unit (1) according to one of the preceding claims,
**characterised in that**
the inner contour (12) is formed in such a way that a clear installation position of the connection unit is determined relative to the moulded part (10).

## Revendications

1. Unité de capteur (1) comprenant :
un capteur (3)
une électronique de capteur (5) reliée au capteur (3), et
une première unité de liaison (7) qui est reliée à l'électronique de capteur (5),
le capteur (3), l'électronique de capteur (5) et la première unité de liaison (7) étant montés dans un boîtier tubulaire (6), et la première unité de liaison (7) pouvant être mise en contact avec une seconde unité de liaison (9) réalisée de façon correspondante,
**caractérisée en ce que**
dans le boîtier (6) est montée solidairement en rotation une pièce usinée (10) ayant un contour interne (12), le contour interne (12) de la pièce usinée (10) et le contour externe (74) de la première unité de liaison (7) étant réalisés au moins par segment de manière correspondante, le contour interne (12) comprenant au moins un segment de retenue (14) qui est réalisé de façon à empêcher une rotation de la première unité de liaison (7) par rapport à la pièce usinée (10).

2. Unité de capteur (1) conforme à la revendication 1,
**caractérisée en ce que**
la pièce usinée (10) comporte un contour interne (12) comprenant au moins deux et de préférence quatre ou six segments de retenue (75).

3. Unité de capteur (1) conforme à l'une des revendications précédentes,
**caractérisée en ce que**
la pièce usinée (10) comporte des segments de retenue (75) opposés par paire et s'étendant parallèlement.

4. Unité de capteur (1) conforme à l'une des revendications précédentes,
**caractérisée en ce que**
la pièce usinée (10) comporte un contour interne (12) en forme de rectangle, d'hexagone régulier ou d'un polygone régulier.

5. Unité de capteur (1) conforme à l'une des revendications 1 et 2,
**caractérisée en ce que**
le contour interne (12) comporte au moins un évidement (16) dirigé vers l'extérieur et le contour externe (74) comprend au moins une saillie venant en prise dans l'évidement.

6. Unité de capteur (1) conforme à la revendication 5,
**caractérisée en ce que**
le contour interne (12) est en forme d'étoile.

7. Unité de capteur (1) conforme à l'une des revendications précédentes,
**caractérisée en ce que**
la pièce usinée (10) est comprimée, collée, soudée ou brasée dans le boîtier (6).

8. Unité de capteur (1) conforme à l'une des revendications précédentes,
**caractérisée en ce que**
la pièce usinée (10) est réalisée en matériau synthétique et de préférence par un procédé de moulage par injection.

9. Unité de capteur (1) conforme à l'une des revendications 1 à 7,
**caractérisée en ce que**
la pièce usinée (10) est réalisée en métal, de préférence en aluminium et de préférence par un procédé de moulage sous pression, ou en acier et de préférence par un procédé de coulage de précision.

10. Unité de capteur conforme à l'une des revendications 1 à 7,
**caractérisée en ce que**
la pièce usinée (10) est réalisée par un procédé de moulage par injection de métal.

11. Unité de capteur (1) conforme à l'une des revendications 1 à 7,
**caractérisée en ce que**
la pièce usinée (10) est réalisée par un procédé par enlèvement de copeaux.

12. Unité de capteur (1) conforme à l'une des revendications précédentes,
**caractérisée en ce que**
les unités de liaison (7, 9) permettent d'obtenir une liaison électrique et la première unité de liaison (7) est réalisée sous la forme d'une douille d'enfichage tandis que la seconde unité de liaison (9) est réalisée sous la forme d'une fiche mâle.

13. Unité de capteur (1) conforme à la revendication 1,
**caractérisée en ce que**
la douille d'enfichage comprend des éléments d'encliquetage qui viennent en prise par encliquetage en arrière de la pièce usinée (10) pour permettre sa fixation axiale.

14. Unité de capteur (1) conforme à l'une des revendications 1 à 13,
**caractérisée en ce que**
la fiche mâle (9) vient en prise dans la douille d'enfichage (7) et peut être fixée sur le boîtier (6) au moyen d'un écrou à collerette de fixation (93).

15. Unité de capteur (1) conforme à l'une des revendications précédentes,
**caractérisée en ce que**
le contour interne (12) est réalisé de façon à permettre de fixer une position de montage précise de l'unité de liaison par rapport à la pièce usinée (10).
